# EUROPEAN PATENT APPLICATION

(11) **EP 4 535 360 A1**
(43) Date of publication of application: **09.04.2025**
(21) Application number: 24200979.3
(22) Date of filing: 18.09.2024
(51) Int. Cl.: G11C 11/417, G11C 7/22, G11C 5/06, G11C 7/12, G11C 7/18, G11C 11/419, G11C 5/02

(54) **PROGRAMMABLE BIT-CELL BASED DISCHARGE CELL FOR READ SELF-TIME TRACKING IN MULTIPORT SRAM**

(30) Priority: 02.10.2023 US 202363542020 P; 26.08.2024 US 202418815356
(71) Applicant: STMicroelectronics International N.V., 1228 Plan-les-Ouates, Geneva (CH)
(72) Inventor: SHRIVASTAVA, Sant Swaroop, 282005 AGRA UTTAR PRADESH (IN); CHAWLA, Hitesh, 201301 NOIDA (IN); GULYANI, Sachin, 201301 NOIDA (IN); IKHLAS, Mohd Javed, 110025 NEW DELHI (IN)
(74) Representative: Casalonga

(57) **Abstract**

A memory system includes a memory array with first dummy read cells that discharge a dummy bit line, each of the first dummy read cells including a transistor coupled between the dummy bit line and a first ground node that is connected to a ground reference. Second dummy read cells discharge the dummy bit line, each of the dummy read cells including a transistor coupled between the dummy bit line and a second ground node. The dummy read cells cooperate to discharge the dummy bit line in a dummy read operation to provide a self-timing signal. Read circuitry retrieves data from a selected row in the memory array during a read operation, in response to the self-timing signal. Ground generation circuitry connects the second ground node to the ground reference or allows the second ground to float, based upon a control signal.

## Description

### RELATED APPLICATION

This application claims priority to United States Provisional Application for Patent No. 63/542,020, filed October 2, 2023, the contents of which are incorporated by reference in their entirety.

### TECHNICAL FIELD

This disclosure is related to the field of Static Random Access Memory (SRAM) and, in particular, to a self-timed SRAM with programmable self-time delay.

### BACKGROUND

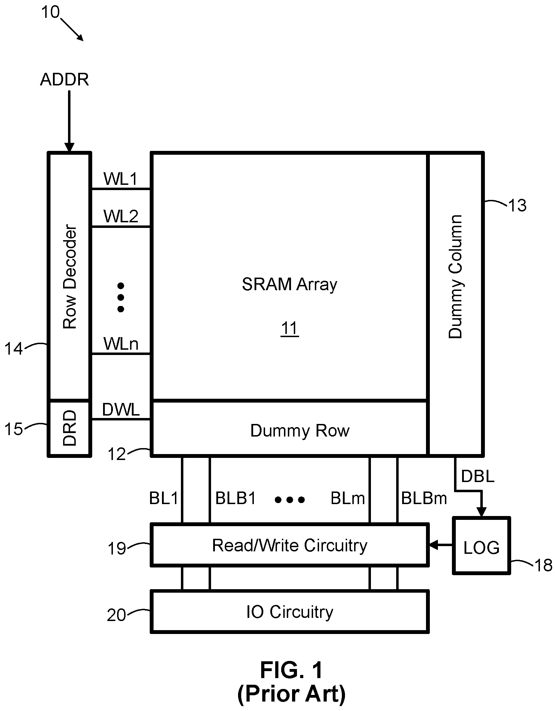

Now described with reference to FIG. 1 is a self-timed Static Random Access Memory (SRAM) system 10. The SRAM system 10 includes a SRAM array 11, dummy row 12, dummy column 13, row decoder 14, dummy row decoder (DRD) 15, self-timed control logic (LOG) 18, read/write circuitry 19, and input/output (IO) circuitry 20.

The SRAM array 11 is comprised of a grid of multiple rows and columns of six-transistor (6T) SRAM cells, each capable of storing a single bit of data. The intersections of wordlines (WL1, ..., WLn) and bitlines (BL1BLB1, ..., BLm/BLBm) form individual cells of SRAM array 11 where the bits of data are read from or written to.

For read operations, row decoder 14 decodes the input address (ADDR) and asserts the appropriate wordline (WL) activating the corresponding SRAM cell in array 11. Activation of the word line WL causes the cells of the selected row in the SRAM array 11 to change the states of their corresponding bitlines (BLBLB) dependent upon the data stored in those cells. These changes are detected by sense amplifiers within the read/write circuitry 19, which are activated in response to an indication from the self-timed control logic 18 that a dummy read is complete.

For write operations, the row decoder 14 decodes the input address and asserts the appropriate wordline (WL) for the targeted SRAM cell in array 11. Concurrently, the desired data to be written is provided to the bitlines (BLBLB) via the input/output circuitry 20. Once the wordline is activated, the SRAM cell connected to it stores the new data by transitioning to a stable state corresponding to the provided bit value. The self-timed control logic 18 terminates the write operation when the write is complete.

Data input/output (I/O) circuitry 20 interfaces SRAM array 11 with the rest of the system. It delivers the data to be written to the SRAM array 11 and routes the read data to the appropriate system output.

The self-timed control logic 18 controls the read/write circuitry 19 in response to delay tracking effectively performed by the dummy row 12 and dummy column 13.

For read operations, the dummy row 12 is designed and positioned to track (e.g., emulate) the worst-case delay for each SRAM cell in the selected row to reflect its state change onto its corresponding bit lines during a read operation. In addition, the dummy column 13 is designed and positioned to track (e.g., emulate) the worst-case bit line delay during a read operation. The dummy read operation begins with the dummy decoder 15 performing a dummy decode and selection of the dummy word line DWL, resulting in state change of the dummy bit lines. When the dummy row 12 and dummy column 13 complete dummy operations (e.g., the voltage level on the dummy bit line has fallen to a level where it can be assumed that a sense amplifier, when activated, would sense, read, and output the correct data value stored in the dummy cell), it can be inferred that the sense amplifiers within the read/write circuitry can be turned on to read the selected row in the SRAM array 11, as the dummy row 12 accounts for the worst-case delay of the cells to impose the proper state changes on their bit lines.

For write operations, the dummy row 12 is designed and positioned to track (e.g., emulate) the worst-case delay for each SRAM cell in the selected row to accept a new data value during a write operation. This accounts for the time it takes for the SRAM cell to store the incoming value. The dummy column 13, during write operations, tracks the worst-case delay associated with establishing the correct data value onto the bit lines, ensuring that the targeted SRAM cell receives the proper data value. The dummy write operation begins with the dummy decoder 15 performing a dummy decode and selection of the dummy word line DWL, and then a write being performed to the dummy cells. When the dummy row 12 and dummy column 13 complete a write operation, it can be assumed that the selected row in the SRAM array 11 has completed its write operation and that the writer drivers within the read/write circuitry 19 can be turned off.

The supply voltage of an SRAM affects the timing of the SRAM cells. As the supply voltage is lowered, the delay of the SRAM cells increases due to the reduced current drive capability of the transistors. This decrease in switching speed arises from the intrinsic relationship between transistor drive strength and supply voltage. Dummy cells may not track the behavior of the regular SRAM cells accurately if they are designed for a specific nominal voltage. Therefore, in a self-timed SRAM system, it is desired that the dummy cells closely mirror the behavior of the core SRAM cells across varying supply voltages. If mismatches occur, compensation mechanisms or design changes might be required to ensure proper self-timing of the SRAM array.

Conventional prior art techniques for adjusting the delays of SRAM cells typically involve either programming a discharge cell (a form of dummy cell used in the dummy column) or adding a capacitive load to the SRAM cells. Programming a discharge cell, however, conventionally requires access to an internal node of the discharge cell, which is not feasible in certain technologies and implementations. Additionally, programming of a discharge cell requires an additional column to be dedicated to programming the discharge cell, which leads to area overhead. Adding a capacitive load to the discharge cells, required at lower voltages, can lead to performance loss, as it takes longer for the discharge cells to charge and discharge.

As such, further development into the development of an SRAM with dummy cells having a programmable delay is needed.

### SUMMARY

Disclosed herein is a memory system, including a memory array, with a first plurality of dummy read cells configured to discharge a dummy bit line, each of the first plurality of dummy read cells including a respective transistor coupled between the dummy bit line and a first ground node, with the first ground node being connected to a ground reference. A second plurality of dummy read cells are configured to discharge the dummy bit line, with each of the second plurality of dummy read cells including a respective transistor coupled between the dummy bit line and a second ground node. The first plurality of dummy read cells and the second plurality of dummy read cells cooperate to discharge the dummy bit line in a dummy read operation to provide a self-timing signal. Read circuitry is configured to retrieve data from a selected row in the memory array during a read operation, in response to the self-timing signal. Ground generation circuitry is configured to connect the second ground node to the ground reference in response to a first state of a control signal and allows the second ground node to float in response to a second state of the control signal.

The memory array may be comprised of rows of SRAM cells, with each SRAM cell having a dual-port design such that it is read through a read port connected to a read bit line. The dummy bit line may be a dummy read bit line. Each of the first plurality of dummy read cells may have a dual-port design such that it is read through a read port connected to the dummy read bit line. Each of the second plurality of dummy read cells may have a dual-port design such that it is read through a read port connected to the dummy read bit line. The read port of each of the second plurality of dummy read cells may include the respective transistor of that dummy read cell.

The read port of each of the second plurality of dummy read cells may include: a first n-channel transistor having a drain connected to the dummy read bit line, a source, and a gate connected to a dummy read word line; and a second n-channel transistor having a drain connected to the source of the first n-channel transistor, a source connected to the second ground node, and a gate connected to a supply voltage. A dummy decoder may be configured to assert the dummy read word line to begin the dummy read operation.

The ground generation circuitry may include: a first n-channel transistor having a drain connected to the second ground node, a source connected to the ground reference, and a gate connected to the control signal; and a second n-channel transistor having a drain connected to the second ground node, a source connected to the ground reference, and a gate connected to a dummy read word line.

The ground generation circuitry may include: a first p-channel transistor having a source connected to a supply voltage, a drain, and a gate connected to a dummy read word line; a second p-channel transistor having a source connected to the drain of the first p-channel transistor, a drain connected to the second ground node, and a gate connected to the control signal; and an n-channel transistor having a drain connected to the second ground node, a source connected to the ground reference, and a gate connected to the control signal.

The dummy bit line may be a dummy read bit line. The first plurality of dummy read cells and the second plurality of dummy read cells may be organized into a dummy read column, with the dummy read bit line running through the dummy read column. A plurality of load cells may be connected to the dummy read bit line to match a capacitance on the dummy read bit line to a capacitance on a bit line of the memory array.

A third plurality of dummy read cells may be configured to discharge the dummy bit line, with each of the third plurality of dummy read cells including a respective transistor coupled between the dummy bit line and a third ground node. Additional ground generation circuitry may be configured to either connect the third ground node to ground or allow the second ground node to float, based upon a control signal.

The additional ground generation circuitry may include: a first n-channel transistor having a drain connected to the second ground node, a source connected to ground, and a gate connected to the control signal; and a second n-channel transistor having a drain connected to the second ground node, a source connected to ground, and a gate connected to a dummy read word line.

The additional ground generation circuitry may include: a first p-channel transistor having a source connected to a supply voltage, a drain, and a gate connected to a dummy read word line; a second p-channel transistor having a source connected to the drain of the first p-channel transistor, a drain connected to the second ground node, and a gate connected to the control signal; and an n-channel transistor having a drain connected to the second ground node, a source connected to ground, and a gate connected to the control signal.

Also disclosed herein is method of reading a memory array. The method includes: decoding an address and asserting a corresponding word line based thereupon; performing a dummy decode to assert a dummy word line; discharging a dummy bit line in response to the assertion of the dummy word line; and in response to the discharging of the dummy bit line, activating IO circuitry to read a row in the memory array corresponding to the asserted word line.

Discharging the dummy bit line includes: discharging the dummy bit line using a first plurality of dummy read cells each utilizing a respective transistor coupled between the dummy bit line and a first ground node connected to a ground reference; activating ground generation circuitry based on a control signal to connect a second ground node to the ground reference in response to a first state of the control signal and allow the second ground node to float in response to a second state of the control signal; and further discharging the dummy bit line using a second plurality of dummy read cells each utilizing a respective transistor coupled between the dummy bit line and the second ground node. The method also includes connecting the second ground node to the ground reference in response to a first state of a control signal and controlling the second ground node to float in response to a second state of the control signal.

The activation of the ground generation circuitry may connect the second ground node to the ground reference in response to the first state of the control signal, allow the second ground node to float in response to the second state of the control signal, and source current to the second ground node in response to the second state of the control signal and deassertion of the dummy word line.

The method may also include: activating additional ground generation circuitry based on a control signal to either connect a third ground node to the ground reference or allow the third ground node to float; and further discharging the dummy bit line using a third plurality of dummy read cells each utilizing a respective transistor coupled between the dummy bit line and the third ground node.

### BRIEF DESCRIPTION OF THE DRAWINGS

FIG. 1 is a block diagram of a prior art memory system.
FIG. 2 is a block diagram of a memory system disclosed herein utilizing dummy cells connected to controllable ground nodes.
FIG. 3. is a schematic diagram of 8T memory cells of the SRAM banks of the memory system of FIG. 2.
FIG. 4A is a schematic diagram of 8T dummy read cells in the dummy read column of the memory system of FIG. 2.
FIG. 4B is a diagrammatical representation of ground traces connected to certain ones of the 8T dummy read cells of FIG. 2.
FIG. 4C is a graph illustrating the setting of different discharge times for the dummy bit line of FIG. 2.
FIG. 5 is first ground signal generation circuitry usable for setting one of the ground traces of FIG. 4B.
FIG. 6 is second ground signal generation circuitry usable for setting one of the ground traces of FIG. 4B.
FIG. 7A is a diagrammatical representation of ground traces connected to certain ones of the 8T dummy read cells of FIG. 2 in an alternative embodiment.
FIG. 7B is a schematic diagram of 8T dummy read cells in the dummy read column of the memory system of FIG. 2 in an alternative embodiment.
FIG. 8 is a schematic diagram of 6T dummy memory cells in the dummy read column of the memory system of FIG. 2 in an alternative embodiment.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

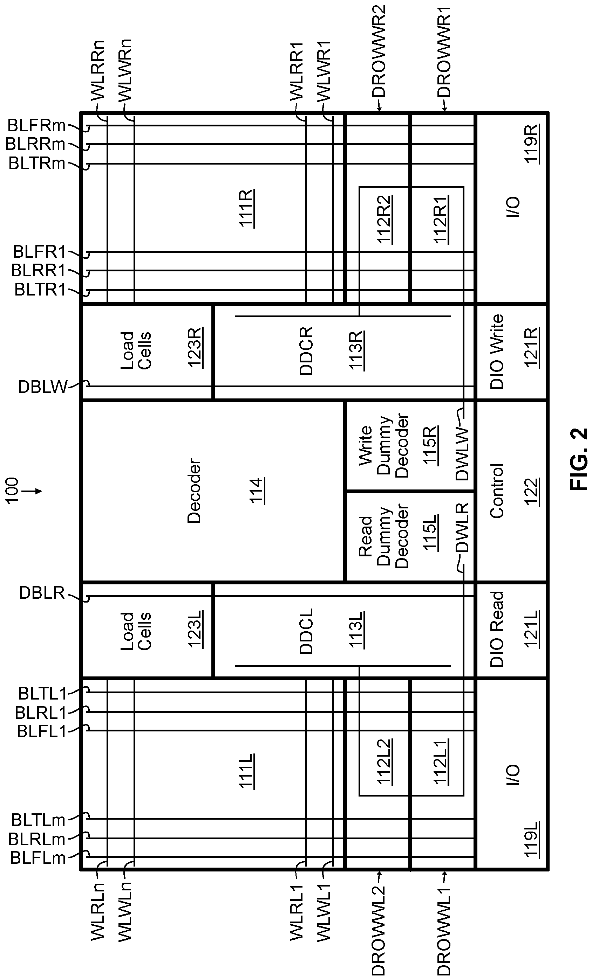

Described initially with reference to FIG. 2 is an SRAM device 100 disclosed herein. The SRAM device 100 includes left SRAM bank 111L and right SRAM bank 111R of 8T SRAM cells.

The SRAM bank 111L is comprised of a grid of multiple rows and columns of the above described 8T SRAM cells, each capable of storing a single bit of data. The intersections of wordlines (WLRL1/WLWL1, ..., WLRLn/WLWLn) and bitlines (BLFL1BLTL1, ..., BLFLmBLTLm) form the individual SRAM cells of the SRAM bank 111L, with each SRAM cell also including a read bitline (BLRL1, ..., BLRLn).

The SRAM bank 111R is comprised of a grid of multiple rows and columns of the above described 8T SRAM cells, each capable of storing a single bit of data. The intersections of wordlines (WLRR1/WLWR1, ..., WLRRn/WLWRn) and bitlines (BLFR1BLTR1, ..., BLFRm/BLTRm) form the individual SRAM cells of the SRAM bank 111R, with each SRAM cell also including a read bitline (BLRR1, ..., BLRRn).

A decoder 114 decodes input addresses and suitably controls the word lines WLRR1/WLWR1, ..., WLRRn/WLWRn for performing reads and writes.

Data input/output (I/O) circuitry 119L interfaces SRAM bank 111L with the rest of the system. It delivers the data to be written to the SRAM bank 111L and routes the read data to the appropriate system output. Likewise, data input/output (I/O) circuitry 119R interfaces SRAM bank 111R with the rest of the system. It delivers the data to be written to the SRAM bank 111R and routes the read data to the appropriate system output.

Associated with the SRAM bank 111L is a read dummy column 113L and two read dummy rows 112L1, 112L2. A dummy read word line DWLR runs from the read dummy decoder 115L, through the read dummy row 112L1 from right to left, and then up to the read dummy row 112L2 and through the read dummy row 112L2 from left to right, into the read dummy column 113L. The read dummy column 113L includes a dummy read bit line DBLR.

Associated with the SRAM bank 111R is a write dummy column 113R and two write dummy rows 112R1, 112R2. A dummy write word line DWLW runs from the write dummy decoder 115R, through the write dummy row 112R1 from left to right, and then up to the write dummy row 112R2 and through the write dummy row 112R2 from right to left, into the write dummy column 113R. The write dummy column 113R includes a dummy write bit line DBLW.

Self-timing of read operations are performed through the use of the read dummy column 113L and two read dummy rows 112L1, 112L2 to track the worst-case delay for each SRAM cell in the selected row of the selected SRAM bank to be read to reflect its state change onto its corresponding bit lines during a read operation, as well as the worst-case bit line delay during a read operation.

For read operations, the decoder 114 decodes the input address and asserts the appropriate read wordline WLR activating the corresponding SRAM cell in SRAM bank being read.

Concurrently, a dummy read operation is performed, which begins with the appropriate dummy read decoder 115L or 115R performing a dummy decode (to imitate the delay of the decoder 114) and selection of the dummy read word line DWLR, resulting in state change of the dummy read bit line DBLR. When the dummy read bit line DBLR has changed state as confirmed by the dummy read I/O 121L or 121R to emulate the delay of a worst performance case SRAM cell changing state to drive its associated bit lines, it can be inferred that the bit lines have sufficiently changed state to be read and that sense amplifiers within the I/O circuitry 119L or 119R can be turned on to read the selected row in the selected SRAM bank 111L or 111R. Therefore, at this point the control circuitry 122 activates (for example, through the assertion of a sense amplifier enable signal (SAEN)) the appropriate sense amplifiers within the appropriate set of I/O circuitry 119L or 119R.

In this process, dummy load cells 123L and 123R serve to match the capacitance on the dummy bit line DBLR to the capacitance on the actual bit lines. Also note the snaking path of the dummy read bit line DBLR through both the dummy read column 113L and the dummy read rows DROWWL1, DROWWL2, helping match the delay on the dummy read word line DWLR to the delay at the worst location on the actual read word line WLR.

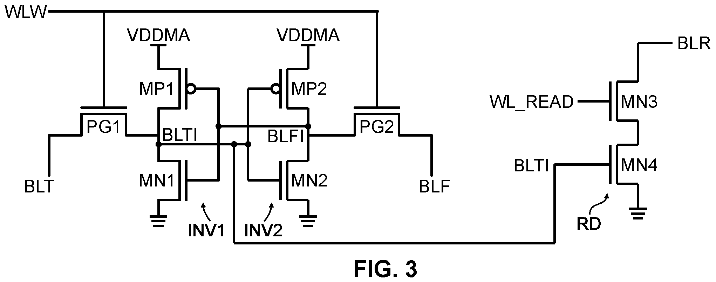

The 8T SRAM cells in the SRAM banks 111L and 111R are dual-port memory cells, having the circuit structure shown in FIG. 3. In particular, each SRAM cell is comprised of a pair of cross coupled inverters INV1, INV2, with pass gate PG1 connected between the output BLTI of inverter INV1 and the bit line BLT, and with pass gate PG2 connected between the output BLFI of inverter INV2 and the bit line BLF. Inverter INV1 is formed by: p-channel transistor MP1 having its source connected to a supply voltage VDDMA, its drain connected to node BLTI, and its gate connected to node BLFI; and n-channel transistor MN1 having its drain connected to node BLTI, its source connected to ground, and its gate connected to node BLFI. Inverter INV2 is formed by: p-channel transistor MP2 having its source connected to supply voltage VDDMA, its drain connected to node BLFI, and its gate connected to node BLTI; and n-channel transistor MN2 having its drain connected to node BLFI, its source connected to ground, and its drain connected to node BLTI. A write word line WLW is connected to the gate terminals of the pass gates PG1 and PG2. Write operations are performed as in a conventional 6T cell.

For read operations, however, the 8T cell includes a read port RP, formed by: n-channel transistor MN3 having its drain connected to read bit line BLR, its source connected to the drain of n-channel transistor MN4, and its gate connected to node receive the read word line signal WLR; and n-channel transistor MN4 having its drain connected to the source of n-channel transistor MN3, its source connected to ground, and its gate connected to node BLTI. The 8T cell is read via the read bit line BLR when the read word line signal WLR is asserted.

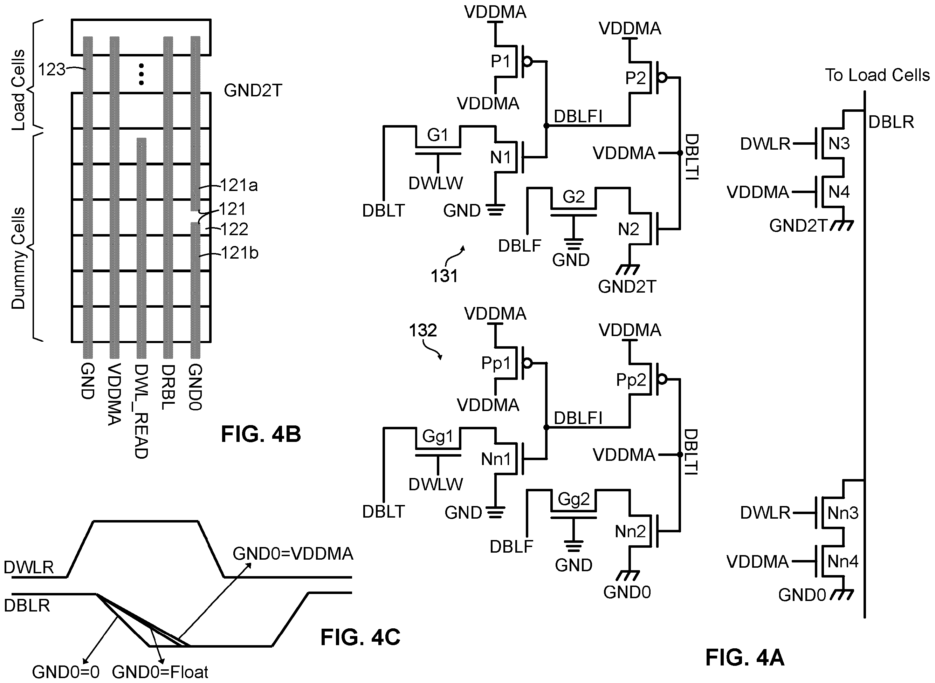

Shown in FIG. 4A are the schematics of the read dummy cells in the read dummy column 113L and the read dummy rows 112L1, 112L2, and shown in FIG. 4B is the layout of ground traces to these read dummy cells. Observe first ground trace 123 connected to GND. Note that the ground trace 121 in FIG. 4B is separated into two portions 121a and 121b connected to different grounds. Ground trace 121a is connected to ground GND2T while ground trace 121b is connected to ground GNDO. Ground GND2T and ground GNDO are separate and distinct signals, with a break in them (due to the break between ground traces 121a and 121b) being present at an isolation cell 122. Certain of the read dummy cells in the read dummy column 113L and the read dummy rows 112L1, 112L2 are connected to ground trace 121a, and certain others of the read dummy cells in the read dummy column 113L and the read dummy rows 112L1, 112L2 are connected to ground trace 121b.

The top illustrated dummy cell 131 is exemplary of the dummy cells connected to ground trace portion 121a, and includes: p-channel transistor P1 having its source connected to a supply node VDDMA, its drain connected to a supply node VDDMA, and its gate connected to node DBLFI; n-channel transistor N1 having its drain connected to a first conduction terminal of pass gate G1, its source connected to ground GND, and its gate connected to node DBLFI; the pass gate G1 having its first conduction terminal connected to the drain of N1, a second conduction terminal connected to dummy bit line DBLT, and a gate connected to the dummy write word line DWLW. The dummy cell 121a further includes: a p-channel transistor P2 having its source connected to the supply node VDDMA, its drain connected to node DBLFI, and its gate connected to supply node VDDMA; an n-channel transistor N2 having its source connected to a first conduction terminal of pass gate G2, its drain connected to ground GND2T (which is a separate ground than GND0, as explained above), and its gate connected to the supply node VDDMA; the pass gate G2 having its first conduction terminal connected to the drain of N2, its second conduction terminal connected to dummy bit line DBLF, and its gate connected to ground GND. The dummy cell also includes: n-channel transistor N3 having its drain connected to the dummy read bit line DBLR, its source connected to the drain of n-channel transistor N4, and its gate connected to dummy read word line DWLR; and the n-channel transistor N4 having its drain connected to the source of n-channel transistor N3, its source connected to ground GND2T (note the source of N2 is also connected to this same ground GND2T), and its gate connected to the supply node VDDMA (note the drain of MP1 is also connected to this node). The bottom illustrated dummy cell 132 is identical, except instead of the sources of Nn2 and Nn4 being connected to the ground GND2T, they are connected to the ground trace portion 121b and therefore ground GNDO.

Of particular note is that the ground GNDO is controllable, enabling the dummy cells 132 having the sources of Nn2 and Nn4 being connected to GNDO to be placed into multiple different conditions. If GNDO is providing a path to ground, then the dummy cells 132 are active. Therefore, when a dummy read is performed, the dummy cells 131 and dummy cells 132 both discharge the dummy read bit line DBLR. If GNDO is instead left floating, then the dummy cells 132 are inactive and when a dummy read is performed, only the dummy cells 131 discharge the dummy read bit line DBLR. Therefore, the time taken to discharge the dummy read bit line DBLR is settable by changing the voltage level of the ground GNDO. For example, refer to FIG. 4C, where it is shown that when GNDO provides a path to ground, the dummy read bit line DBLR is discharged more quickly than when GNDO is left floating, and that when GNDO is left floating, the dummy read bit line DBLR is discharged more quickly than when GNDO is coupled to VDDMP.

It should be understood that any number of read dummy cells in the read dummy column 113L and the read dummy rows 112L1, 112L2 may be connected to ground trace 121a (and therefore GND2T) and any number may instead be connected to ground trace 121b (and therefore GNDO), providing for the ability to set/adjust the specific delay in discharging DBLR for situations where GNDO is left floating or where GNDO is coupled to VDDMP.

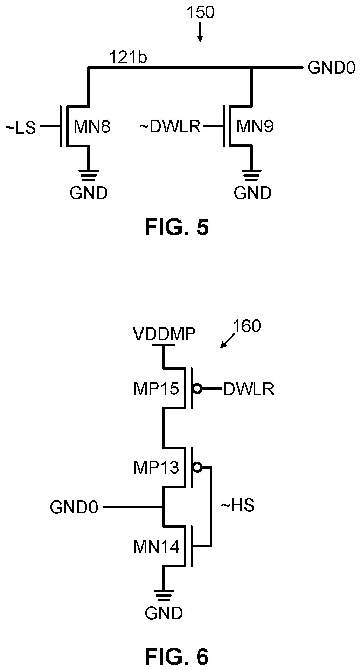

Now described with reference to FIG. 5 is a ground generation circuit 150 for generating GNDO on the ground trace 121b. The ground generation circuit 150 includes: an n-channel transistor MN8 having its drain connected to ground trace 121b, its source connected to ground trace 123 and therefore GND, and its gate connected to the complement ~LS of a control signal LS; and an n-channel transistor MN9 having its drain connected to ground trace 121b, its source connected to ground trace 123 and therefore ground GND, and its gate connected to the complement -DWLR of the dummy read word line DWLR.

Here, if the control signal ~LS is at a logic high, then during a read (at which DWLR is at a high and therefore -DWLR is at a low), transistor MN8 is turned on, and there is a path from GNDO to GND, so the dummy read cells having certain transistors connected to GNDO are operational, providing a discharge path to ground. If the signal -LS is at a logic low, then during a read (at which DWLR is at a high and therefore -DWLR is at a low), there is no path from GNDO to GND, and GNDO floats, so the dummy cells having certain transistors connected to GNDO are not operational and do not provide a path to ground (other than via leakage current). As can be understood, this embodiment does not provide for the sourcing of current from GNDO (e.g., the connection of VDDMP to GNDO).

Now described with reference to FIG. 6 is another ground generation circuit 160 for generating GNDO on the ground trace 121b. The ground generation circuit 160 includes: a p-channel transistor MP15 having a source connected to VDDMP, a drain connected to the source of p-channel transistor MP13, and a gate connected to the dummy read word line DWLR; the p-channel transistor MP13 having its source connected to the drain of p-channel transistor MP15, its drain connected to ground trace 121b, and its gate coupled to a complement ~HS of a control signal HS; and an n-channel transistor MN14 having its drain connected to ground trace 121b, its source connected to ground, and its gate connected to the complement ~HS of the control signal HS.

Here, if the control signal ~HS is at a logic high, then during a read (at which DWLR is at a high), transistor MN14 is turned on, and there is a path from GNDO to GND, so the dummy cells having certain transistors connected to GNDO are operational, providing a discharge path to ground. If the signal ~HS is at a logic low, then during a read (at which DWLR is at a high), there is no path from GNDO to GND, and GNDO floats, so the dummy cells having certain transistors connected to GNDO are not operational and do not provide a path to ground (other than via leakage current). However, if the signal ~HS is at a logic low when DWLR is also at a logic low, then current is sourced to GNDO through p-channel transistors MP15 and MP13, increasing the time to discharge the dummy read bit line DBLR in a later operation.

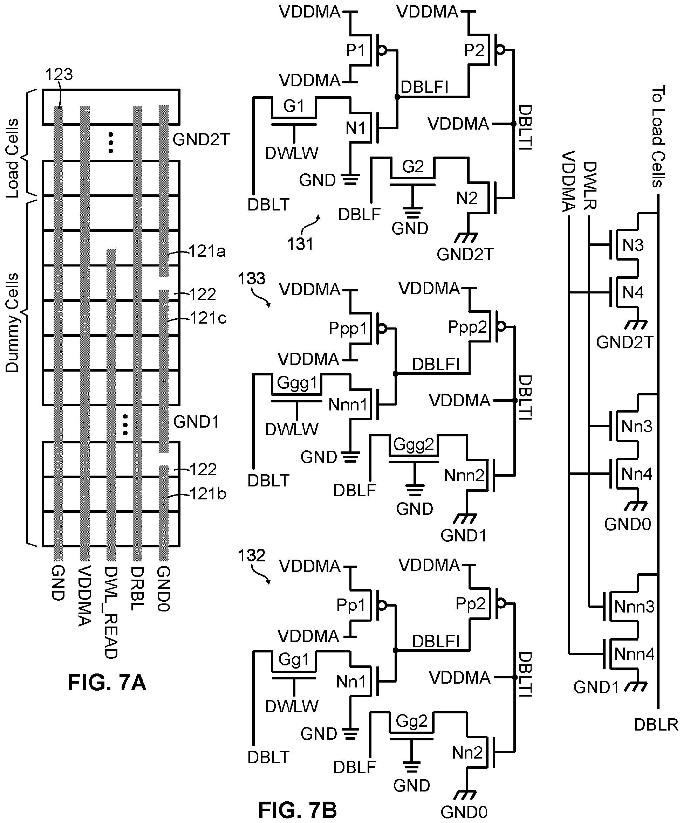

It should also be appreciated that the trace 121 forming trace 121a carrying ground GND2T and trace 121b carrying ground GNDO may be separated into three or more sections. Refer now to FIG. 7A, showing how the trace 121 may be split into trace 121a carrying ground GND2T, trace 121c carrying ground GND1, and trace 121b carrying ground GNDO. In these instanced, as shown in FIG. 7B, the dummy cell 131 may be connected to ground trace 121a to receive GND2T, the dummy cell 133 may be connected to ground trace 121c to receive GND1, and the dummy cell 132 may be connected to ground trace 121b to receive GNDO.

The dummy cells 131 and 132 are as in the previously discussed embodiment, and the dummy cell 133 is identical, except instead of the sources of Nnn2 and Nnn4 being connected to the ground GND0, they are connected to the ground trace portion 121c and therefore ground GND1.

GND1 may generated by ground generator 150 or 160 as described above, with the ground generator for GND1 and the ground generator for GNDO being independently controllable to provide for more granularity in how many dummy cells are either active, left with certain of their grounds floating, or left with sourcing current from certain of their ground nodes.

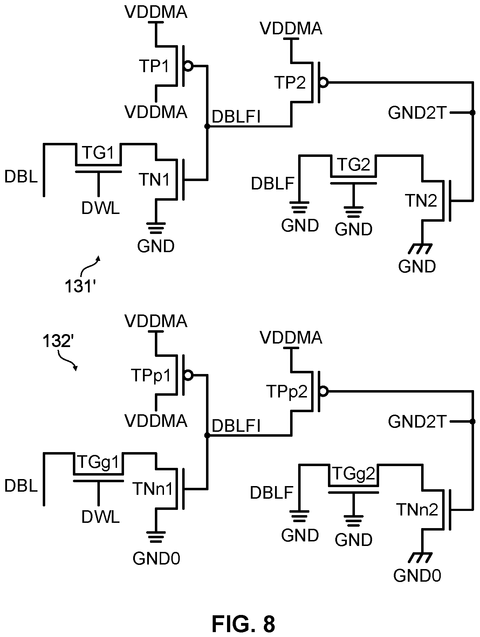

The same principles are also applicable to standard single port SRAMs and their dummy cells. For example, shown in FIG. 8 are single port dummy cells 131' and 132'. The single port dummy cell 131' is exemplary of the dummy cells connected to ground trace portion 121a, and includes: a p-channel transistor TP1 having its source connected to VDDMA, its drain connected to VDDMA, and its gate connected to node DBLFI; an n-channel transistor TN1 having its drain connected to first conduction terminal of pass gate TG1, its source connected to ground, and its gate connected to DBLFI; a p-channel transistor TP2 having its source connected to VDDMA, its drain connected to node DBLFI, and its gate connected to GND; an n-channel transistor TN2 having its drain connected to the first conduction terminal of pass gate TG2, its source connected to ground, and its gate connected to GND; the pass gate TG1 having its first conduction terminal connected to the drain of the n-channel transistor TN1, its second conduction terminal connected to the dummy bit line DBL, and its gate connected to the dummy word line DWL; and the pass gate TG2 having its first conduction terminal connected to the drain of the n-channel transistor TN2, its second conduction terminal connected to dummy bit line DBLF, and its gate connected to GND. The dummy cell 132' is identical to the dummy cell 131', except instead of the sources of TNn2 and TNn4 being connected to the ground GND, they are connected to the ground trace portion 121b and therefore ground GNDO. Operation of the ground generators 150 or 160 to generate GNDO and GND1 remains the same as described above.

It should be appreciated that there may be any such number of grounds (GNDO, GND1, GND2, etc.), with the ground trace 121 being divided into an equal number of disconnected traces. Likewise, different ones of the read dummy cells in the read dummy column 113L and the read dummy rows 112L1, 112L2 may be connected to different ones of these grounds to provide a high degree of granularity of control over the discharge time of the dummy read bit line DBLR. Indeed, as explained above, through this arrangement, the discharge time of the DBLR can be finely tuned. For instance, if a quicker discharge time is necessary, certain grounds from among GND0, GND1, GND2, etc., can be toggled to provide a direct discharge path for certain read dummy cells. Conversely, if a slower discharge is desired, other grounds from among GND0, GND1, GND2, etc., can be floated or even caused to source current. This grounding approach not only enhances the flexibility in controlling the discharge time of the dummy read bit line DBLR but also helps optimize power efficiency and performance according to the demands of specific operational scenarios.

In conclusion, the disclosure addressing several challenges of conventional self timed memories. Traditional programming of discharge cells relied heavily on accessing the bit-cell internal node - a process increasingly unworkable with the evolution of advanced technology nodes. The design disclosed herein bypasses this issue by programming through the bit-cell ground supply, paving the way for multiple advantages. For example, among these is enhanced PVT (Process, Voltage, Temperature) tracking, underlined by a comparison between the new design - which reduces the number of discharge cells - and the prior art design that necessitates adding extra load. Such improvements provides for better performance as well as increased area efficiency. Another advantage is the adaptability of the design across various voltage domains. Higher voltage domains govern the number of dummy discharge cells needed. For lower voltage domains, slowing down the Self-Time path to clear the design margin is performed by this design.

Finally, it is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A memory system, comprising:
a memory array;
a first plurality of dummy read cells configured to discharge a dummy bit line, each of the first plurality of dummy read cells including a respective transistor coupled between the dummy bit line and a first ground node, wherein the first ground node is connected to a ground reference;
a second plurality of dummy read cells configured to discharge the dummy bit line, each of the second plurality of dummy read cells including a respective transistor coupled between the dummy bit line and a second ground node;
wherein the first plurality of dummy read cells and the second plurality of dummy read cells cooperate to discharge the dummy bit line in a dummy read operation to provide a self-timing signal;
read circuitry configured to retrieve data from a selected row in the memory array during a read operation, in response to the self-timing signal; and
ground generation circuitry configured to connect the second ground node to the ground reference in response to a first state of a control signal and allows the second ground node to float in response to a second state of the control signal.

2. The memory system of claim 1,
wherein the memory array is comprised of rows of SRAM cells, each SRAM cell having a dual-port design such that it is read through a read port connected to a read bit line;
wherein the dummy bit line is a dummy read bit line;
wherein each of the first plurality of dummy read cells has a dual-port design such that it is read through a read port connected to the dummy read bit line;
wherein each of the second plurality of dummy read cells has a dual-port design such that it is read through a read port connected to the dummy read bit line; and
wherein the read port of each of the second plurality of dummy read cells includes the respective transistor of that dummy read cell.

3. The memory system of claim 2,
wherein the read port of each of the second plurality of dummy read cells comprises:
a first n-channel transistor having a drain connected to the dummy read bit line, a source, and a gate connected to a dummy read word line; and
a second n-channel transistor having a drain connected to the source of the first n-channel transistor, a source connected to the second ground node, and a gate connected to a supply voltage; and
further comprising a dummy decoder configured to assert the dummy read word line to begin the dummy read operation.

4. The memory system of claim 1, wherein the ground generation circuitry comprises:
a first n-channel transistor having a drain connected to the second ground node, a source connected to the ground reference, and a gate connected to the control signal; and
a second n-channel transistor having a drain connected to the second ground node, a source connected to the ground reference, and a gate connected to a dummy read word line.

5. The memory system of claim 1, wherein the ground generation circuitry comprises:
a first p-channel transistor having a source connected to a supply voltage, a drain, and a gate connected to a dummy read word line;
a second p-channel transistor having a source connected to the drain of the first p-channel transistor, a drain connected to the second ground node, and a gate connected to the control signal; and
an n-channel transistor having a drain connected to the second ground node, a source connected to the ground reference, and a gate connected to the control signal.

6. The memory system of claim 1,
wherein the dummy bit line is a dummy read bit line;
wherein the first plurality of dummy read cells and the second plurality of dummy read cells are organized into a dummy read column, with the dummy read bit line running through the dummy read column; and
a plurality of load cells connected to the dummy read bit line to match a capacitance on the dummy read bit line to a capacitance on a bit line of the memory array.

7. The memory system of claim 1, further comprising:
a third plurality of dummy read cells configured to discharge the dummy bit line, each of the third plurality of dummy read cells including a respective transistor coupled between the dummy bit line and a third ground node; and
additional ground generation circuitry configured to either connect the third ground node to ground or allow the second ground node to float, based upon a control signal.

8. The memory system of claim 7, wherein the additional ground generation circuitry comprises:
a first n-channel transistor having a drain connected to the second ground node, a source connected to ground, and a gate connected to the control signal; and
a second n-channel transistor having a drain connected to the second ground node, a source connected to ground, and a gate connected to a dummy read word line.

9. The memory system of claim 7, wherein the additional ground generation circuitry comprises:
a first p-channel transistor having a source connected to a supply voltage, a drain, and a gate connected to a dummy read word line;
a second p-channel transistor having a source connected to the drain of the first p-channel transistor, a drain connected to the second ground node, and a gate connected to the control signal; and
an n-channel transistor having a drain connected to the second ground node, a source connected to ground, and a gate connected to the control signal.

10. A method of reading a memory array, the method comprising:
decoding an address and asserting a corresponding word line based thereupon;
performing a dummy decode to assert a dummy word line;
discharging a dummy bit line in response to the assertion of the dummy word line; and
in response to the discharging of the dummy bit line, activating IO circuitry to read a row in the memory array corresponding to the asserted word line;
wherein discharging the dummy bit line comprises:
discharging the dummy bit line using a first plurality of dummy read cells each utilizing a respective transistor coupled between the dummy bit line and a first ground node connected to a ground reference;
activating ground generation circuitry based on a control signal to connect a second ground node to the ground reference in response to a first state of the control signal and allow the second ground node to float in response to a second state of the control signal; and
further discharging the dummy bit line using a second plurality of dummy read cells each utilizing a respective transistor coupled between the dummy bit line and the second ground node; and
connecting the second ground node to the ground reference in response to a first state of a control signal and controlling the second ground node to float in response to a second state of the control signal.

11. The method of claim 10, wherein the activation of the ground generation circuitry connects the second ground node to the ground reference in response to the first state of the control signal, allows the second ground node to float in response to the second state of the control signal, and sources current to the second ground node in response to the second state of the control signal and deassertion of the dummy word line.

12. The method of claim 10, further comprising:
activating additional ground generation circuitry based on a control signal to either connect a third ground node to the ground reference or allow the third ground node to float; and
further discharging the dummy bit line using a third plurality of dummy read cells each utilizing a respective transistor coupled between the dummy bit line and the third ground node.

13. A memory system, comprising:
a memory array;
at least one first dummy read cell coupled between a dummy bit line and a first ground node;
at least one second dummy read cell coupled between the dummy bit line and a second ground node, wherein the first ground node is connected to a ground reference; and
ground generation circuitry configured to selectively control connection of the second ground node to ground, to a current source, or to float, based upon a control signal and a dummy word line to thereby delay in discharging of the dummy bit line to ground during a dummy read operation to generate a self-time signal for the memory array.

14. The memory system of claim 13, wherein the ground generation circuitry comprises:
a first n-channel transistor having a drain connected to the second ground node, a source connected to ground, and a gate connected to the control signal; and
a second n-channel transistor having a drain connected to the second ground node, a source connected to ground, and a gate connected to the dummy word line.

15. The memory system of claim 13, wherein the ground generation circuitry comprises:
a first p-channel transistor having a source connected to a supply voltage, a drain, and a gate connected to a dummy read word line;
a second p-channel transistor having a source connected to the drain of the first p-channel transistor, a drain connected to the second ground node, and a gate connected to the control signal; and
an n-channel transistor having a drain connected to the second ground node, a source connected to ground, and a gate connected to the control signal.

16. A memory system, comprising:
a SRAM array;
a segmented grounding trace system including a plurality of individually settable ground nodes and ground generation circuitry configured to control each of the individually settable ground nodes to provide a grounded path, a floating state, or current source; and
a plurality of dummy read cells, each including a respective transistor coupled between a dummy bit line and one of the individually settable ground nodes.

17. The memory system of claim 16, wherein the ground generation circuitry comprises:
a first n-channel transistor having a drain connected to a ground node from among the individually settable ground nodes, a source connected to ground, and a gate connected to a control signal; and
a second n-channel transistor having a drain connected to the ground node, a source connected to ground, and a gate connected to a dummy read word line.

18. The memory system of claim 16, wherein the ground generation circuitry comprises:
a first p-channel transistor having a source connected to a supply voltage, a drain, and a gate connected to a dummy read word line;
a second p-channel transistor having a source connected to the drain of the first p-channel transistor, a drain connected to a ground node from among the individually settable ground nodes, and a gate connected to a control signal; and
an n-channel transistor having a drain connected to the ground node, a source connected to ground, and a gate connected to the control signal.
